# EUROPEAN PATENT SPECIFICATION

(11) **EP 3 156 206 B1**
(45) Date of publication and mention of the grant of the patent: **24.10.2018**
(21) Application number: 15805754.7
(22) Date of filing: 08.06.2015
(51) Int. Cl.: B29C 59/04, B29C 33/38, B32B 37/00, B32B 38/06

(54) **TRANSFER ROLL FOR IMPRINTING**
ÜBERTRAGUNGSROLLE ZUM PRÄGEN
ROULEAU DE TRANSFERT POUR L'ESTAMPAGE

(30) Priority: 11.06.2014 JP 2014120434
(43) Date of publication of application: 19.04.2017
(73) Proprietor: Soken Chemical & Engineering Co., Ltd., Toshima-ku Tokyo 171-8531 (JP)
(72) Inventor: MIZUKAMI, Yutaka, Sayama-shi Saitama 350-1320 (JP)
(74) Representative: Dehns
(86) International application number: PCT/JP2015/066438
(87) International publication number: WO 2015/190423

(56) References cited:
- WO-A1-2014/080857
- DE-U1- 8 717 479
- JP-A- 2002 001 812
- JP-A- 2011 224 850
- US-A1- 2012 312 457

## Description

### Technical Field

The present invention relates to an imprinting transfer roll for use in an imprinting device.

### Background Art

Nanoimprinting technique is a technique to press a mold having a recessed-protruded pattern formed thereon against a liquid resin or the like on a substrate to transfer the pattern of the mold to the resin. As recessed-protruded patterns, patterns ranging from nanoscale patterns of 10 nm level to patterns of about 100 µm are present, and they are used in various fields, such as fields of semiconductor materials, optical materials, storage media, micromachines, biotechnology and environment.

Devices for use in the nanoimprinting technique include devices of roll transfer system, such as a device of so-called roll-to-plate system to transfer the shape of a mold on a roll to a resin on a flat substrate and a device of so-called roll-to-roll system to transfer the shape of a mold on a roll to a resin on a roll.

For fixing a mold to a roll in the roll transfer system, a method comprising fixing a mold made of a film, which has been affixed to a film, to a roll by means of a pressure-sensitive adhesive tape has been carried out. However, when a pressure-sensitive adhesive tape is used in such a manner, there area problem of occurrence of a difference in level attributable to the pressure-sensitive adhesive tape and a problem that the alignment of the mold with a transfer object resin varies for each production lot because the adhesion position on the roll in the width direction of the roll and the adhesion angle to the roll cannot be accurately determined.

In a patent literature 1, therefore, it is described that plural plate molds each having a recessed-protruded pattern on a surface are fixed to a cylinder through engaging portions. In this method, however, the recessed-protruded pattern is formed by electroforming and has poor versatility.

In a patent literature 2, it is described that a block having a sectorial section is cut out from a cylindrical core, then chuck portions each having magnetic force are provided on surfaces of this block and a residual core which come into contact with each other, and a film having a resin mold affixed thereto is interposed between the chuck portions to fix the film having a resin mold affixed thereto.

In this method, however, it is necessary to provide chuck portions having magnetic force in order to fix the film having a resin mold affixed thereto, and therefore, much time and labor are needed to prepare the device.

Then, a fixing method capable of accurately setting alignment of a mold with an imprinting object in a simple manner has been desired.

### Citation List

### Patent Literature

Patent literature 1: Japanese Patent No. 5200669
Patent literature 2: Japanese Patent Laid-Open Publication No. 2011-251797

### Summary of Invention

### Technical Problem

The present invention addresses the problem of fixing a resin mold to the accurate position on a roll used in an imprinting device of roll transfer system in a simple manner and thereby facilitating control of alignment of the resin mold with a transfer object resin.

### Solution to Problem

The present invention relates to, for example, the following [1] to [5] .
[1] An imprinting transfer roll comprising a roll body around a peripheral surface of which a resin film substrate is to be wound, to said resin film substrate a resin mold having a fine recessed-protruded pattern formed on its surface having been affixed, wherein:
   the roll body is divided into two and thereby constituted of one divided body and the other divided body, and between divided faces of these first divided body and second divided body to be joined together, one end of the resin film substrate is to be sandwiched to integrate the first divided body and the second divided body, and then the resin film substrate is to be wound around in the circumferential direction of the roll body.
[2] The imprinting transfer roll as stated in [1], wherein a pin protrudes from the divided face of the one divided body, a pin hole fitted to the pin is formed on the joint surface of the other divided body, and the one divided body and the other divided body are integrated by pinned connection constituted of the pin and the pin hole.
[3] The imprinting transfer roll as stated in [2], wherein in one end part of the resin film substrate, at least one mounting hole is formed, and the one divided body and the other divided body are integrated in a state where the pin is mounted into this mounting hole.
[4] The imprinting transfer roll as stated in [2], wherein the angle α between the divided face of the divided body having a pin and a tangent line to the roll body on the outer periphery of the roll body at the divided face is 91° to 170°.
[5] An imprinting transfer roll having a recessed-protruded pattern on its surface, said imprinting transfer roll comprising the imprinting transfer roll as stated in any one of [1] to [4] around which a resin film substrate having a resin mold affixed thereto has been wound.

### Advantageous Effects of Invention

According to the present invention, a resin mold can be set at the accurate position on a roll and fixed thereto by a simple method comprising sandwiching one end of a resin film substrate having a resin mold affixed thereto between two divided bodies obtained by dividing a roll body into two and preferably inserting a pin provided on one divided body into a mounting hole provided in the above one end part of the resin film substrate. As a result, alignment of the resin mold with a transfer object resin can be readily controlled. Moreover, a difference in level is not formed on the resin film substrate and the resin mold during the fixing process.

### Brief Description of Drawings

[Fig. 1] Fig. 1 shows exploded perspective views of an imprinting transfer roll of the present invention and a resin film substrate having a resin mold affixed thereto.
[Fig. 2] Fig. 2 is a sectional side view of an imprinting transfer roll of the present invention.
[Fig. 3] Fig. 3 is a perspective view of one divided body of an imprinting transfer roll of the present invention, to said one divided body a resin film having been fitted.
[Fig. 4] Fig. 4 is a top view of an imprinting transfer roll formed in accordance with a preferred embodiment of the present invention.
[Fig. 5] Fig. 5 is a sectional side view of an imprinting transfer roll constituted in accordance with another embodiment of the present invention.

### Description of Embodiments

The imprinting transfer roll according to a preferred embodiment of the present invention will be described hereinafter referring to the attached drawings.

The imprinting transfer roll of the present invention is an imprinting transfer roll comprising a roll body around a peripheral surface of which a resin film substrate is to be wound, to said resin film substrate a resin mold having a fine recessed-protruded pattern formed on its surface having been affixed, wherein:
the roll body is divided into two and thereby constituted of one divided body and the other divided body, and between divided faces of these first divided body and second divided body to be joined together, one end of the resin film substrate is to be sandwiched to integrate the first divided body and the second divided body, and then the resin film substrate is to be wound around in the circumferential direction of the roll body.

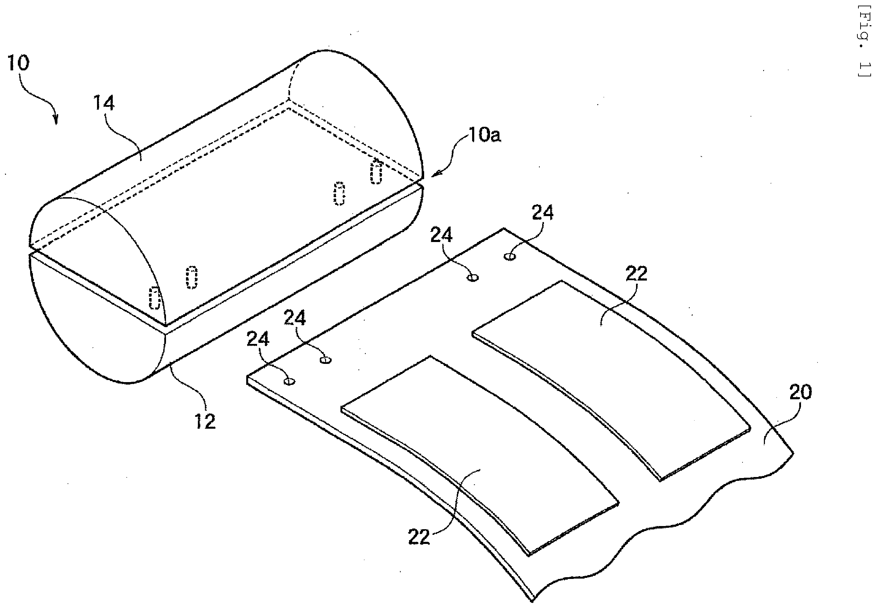

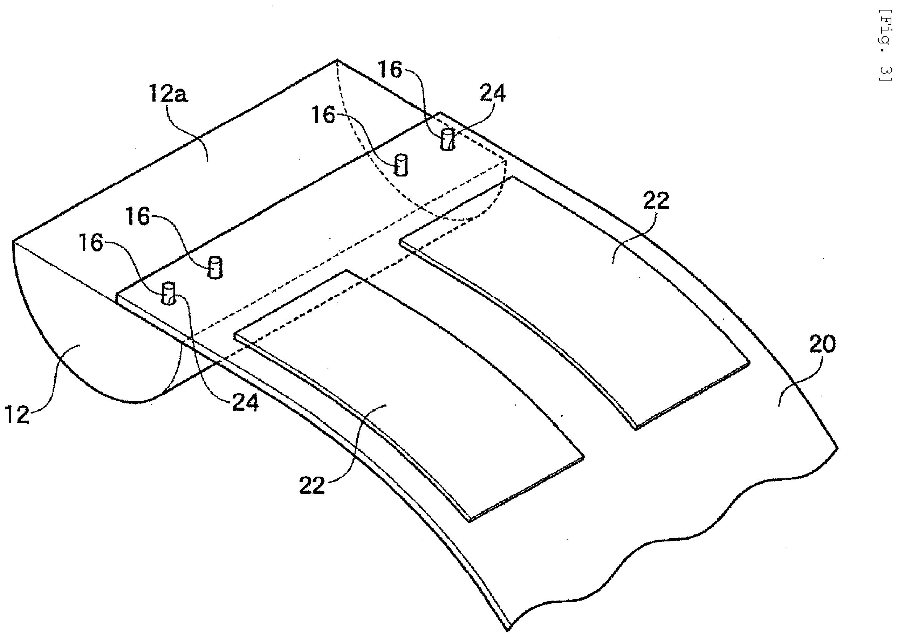

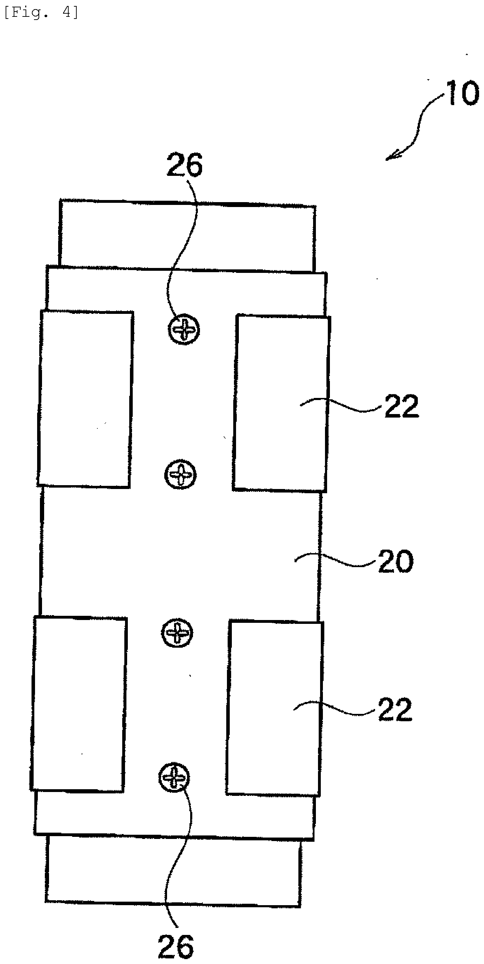

Fig. 1 to Fig. 4 each show an imprinting transfer roll according to a preferred embodiment of the present invention.

In this imprinting transfer roll 10, a roll body 10a is divided into two and thereby constituted of a first divided body 12 and a second divided body 14. When the roll body is divided into two, the sizes of the first divided body 12 and the second divided body 14 are not restricted at all, and the roll body may be divided in the middle to form the first divided body 12 and the second divided body 14 having the same shapes as each other, or the size of one divided body may be made larger than that of the other divided body. As a dividing mode, the roll body 10a may be divided into two by a plane parallel to the axial direction of the roll body or may be divided into a sectorial shape.

The material of the roll body 10a is not specifically restricted, and preferred examples of the materials include metals, rubbers, plastics, ceramics, quartz and glasses.

In an embodiment wherein the roll body 10a is divided into two by a plane parallel to the axial direction of the roll body, it is preferable that plural pins 16 (four pins in this embodiment) protrude from a divided face 12a of the first divided body 12.

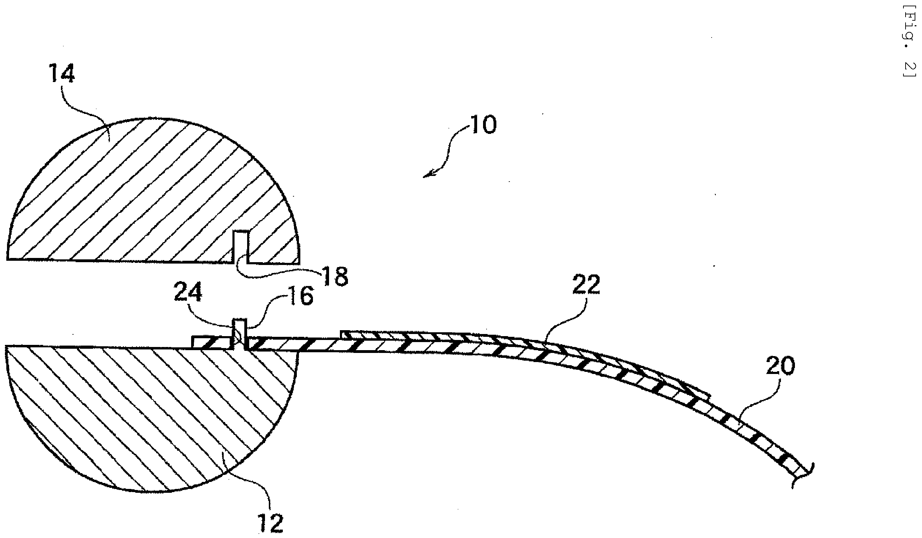

On the other hand, it is preferable that in the second divided body 14, pin holes 18 are formed at the positions corresponding to the pins 16, respectively, as shown in Fig. 2. By virtue of this, the roll body 10a thus divided into two is set in such a manner that when the divided faces of the first divided body 12 and the second divided body 14 are fitted to each other, these divided bodies can undergo pinned connection by means of the pins 16 and the pin holes 18.

The angle α between the divided face (face having pins protruding therefrom) formed by the divided portion 12 and a tangent line to the roll body 10a on the outer periphery of the roll body 10a at the divided face is preferably in the range of 91° to 170°, more preferably in the range of 105° to 150°. That is to say, with regard to the abutting faces of the first divided body 12 and the second divided body 14, one of them may protrude at an angle in the range of 91° to 170° and the other may be formed of a concave curved face. When the roll body 10a is so divided as to form such an angle, a stress occurring is small even if the resin mold 22 is wound around, and therefore, the recessed-protruded pattern tends to be maintained.

For the resin film substrate 20 and the resin mold 22, publicly known materials can be used, but preferable are materials described in WO2011/016549, WO2011/018043, WO2011/018045 and WO2011/018048 previously applied by the present applicant.

The above materials may contain components, such as antioxidant, photosensitizer, filler and leveling agent, in such a range as exerts no influence on the properties of the resin.

The thickness of the resin mold 22 is usually 50 nm to 300 µm, preferably 500 nm to 10 µm. When the thickness of the resin mold is in the above range, the resin mold not only has strength to withstand imprinting but also has good smoothness and ease of handling. Here, the thickness of the resin mold refers to a distance between the bottom surface of the resin layer and the highest plane of the recessions and protrusions on the surface.

The recessed-protruded pattern on the surface of the resin mold 22 is a pattern in which a recession and a protrusion are repeated in a certain cycle, and preferable is a recessed-protruded pattern having a cycle of 10 nm to 50 cm, a depth of 10 nm to 100 µm and a transfer surface of 1.0 to 1.0×10⁶ mm². Examples of specific shapes of the recessions and protrusions include line, column, monolith, cone, pyramid and microlens.

The length of the resin mold 22 in the outer circumferential direction of the roll is not specifically restricted, and the length may be shorter or longer than the length of the outer periphery of the roll, but from the viewpoint that the resin mold is stably seized to the roll, it is preferable that the length of the resin mold is exactly the same as the length of the outer periphery of the roll. When the length of the resin mold is shorter than the length of the outer periphery of the roll, the shortage portion may be filled with a peelable resin in accordance with the description of WO2013/031460.

In one end part of the resin film substrate 20, mounting holes 24 are preferably formed at certain intervals so that the pins 16 protruding from the first divided body 12 can be mounted into them, as shown in Fig. 1 to Fig. 3. It is preferable that these mounting holes 24 are formed in such a manner that their diameters are a little larger than the diameters of the pins 16.

It is preferable that in the first place the resin film substrate 20 formed as above is so arranged as to face the divided face of the first divided body 12, and the pins 16 are inserted into the mounting holes 24, respectively. By virtue of this, one end part of the resin film substrate 20 is temporarily fixed to the first divided body 12.

Thereafter, the second divided body 14 is so arranged as to face the first divided body 12, and the pins 16 are fitted into the pin holes 18 in a manner in which the resin film substrate 20 is sandwiched between the divided bodies, as shown in Fig. 2.

By the simple method in which pins 16 are allowed to protrude from the divided body 12 and pin holes 18 are provided in the divided body 14, as described above, not only can the resin film substrate 20 be fixed to the determined position but also the divided bodies 12 and 14 can be fitted to each other.

Referring to Fig. 1 to Fig. 3, the method to fix the resin film substrate 20 to the roll body 10a is described hereinbefore taking, as an example, a method of inserting the pins 16 into the mounting holes 24 of the resin film substrate 20. However, the method to fix the resin film substrate 20 to the roll body 10a is not limited to the above method, and other methods may be adopted. Examples of other methods to fix the resin film substrate 20 to the roll body 10a include a method comprising applying a pressure-sensitive adhesive to the divided face 12a of the divided body 12 and/or the divided face of the divided body 14 and affixing one endpart of the resin film substrate 20 to the divided face, a method comprising applying a pressure-sensitive adhesive tape to the divided face 12a of the divided body 12 and/or the divided face of the divided body 14 and affixing one end part of the resin film substrate 20 to the divided face, and a method comprising giving concave and convex shapes to the divided face 12a of the first divided body 12 and the divided face of the second divided body 14 and sandwiching one end of the resin film substrate 20 between the divided body 12 and the divided body 14.

Examples of methods to integrate the first divided body 12 and the second divided body 14 include a method of advancing screws 26 from a peripheral surface of the second divided body 14 toward the first divided body 12 and a method of forming magnetic materials different in magnetic pole on the divided face of the first divided body 12 and the divided face of the second divided body 14.

By winding the resin film substrate 20 around the roll body 10a from this state, the resin film substrate 20 is integrally wound around the roll body 10a.

Between the peripheral surface of the roll body 10a and the resin film substrate 20, a pressure-sensitive adhesive or the like maybe interposed to integrate the roll body and the resin film substrate, or a member having adhesion to the material of the roll body 10a may be adopted to integrate the roll body and the resin film substrate. Such an adhesion means between the peripheral surface of the roll body 10a and the resin film substrate 20 is not restricted at all, but for example, a removable pressure-sensitive adhesive, a pressure-sensitive adhesive containing an acrylic-silicone-based copolymer, a pressure-sensitive adhesive containing silicone oil, silicone rubber, etc. can be mentioned. In a preferred embodiment, a pressure-sensitive adhesive tape is laminated on a surface side of the resin film substrate 20, on said surface side the recessed-protruded pattern having been not formed, and the constitution and the adhesive strength of the pressure-sensitive adhesive tape are preferably within the ranges described in WO2013/031710.

Thus, an imprinting transfer roll 10 according to the present embodiment can be formed.

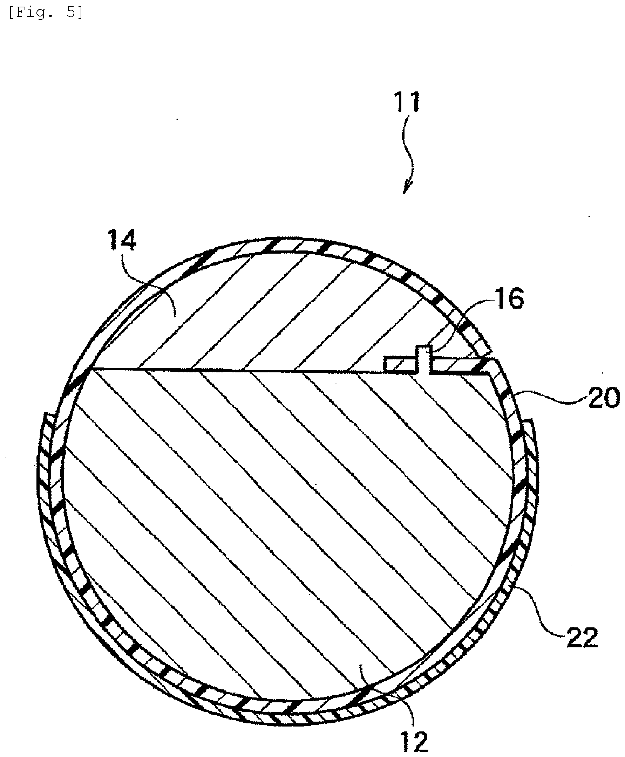

In the imprinting transfer roll 10 according the present embodiment, the resin film 20 having the resin mold 22 affixed thereto is integrally wound around the roll body 10a, as described above, whereby an imprinting transfer roll 11 having a recessed-protruded pattern on its surface is formed, as shown in Fig. 5.

The imprinting transfer roll 11 can be used in devices of roll transfer system, such as a device of roll-to-plate system and a device of roll-to-roll system, and in these devices, the imprinting transfer roll 11 is used in order to transfer the recessed-protruded pattern present on the surface of the resin mold 22 to a transfer object resin. Specifically, the imprinting transfer roll 11 is pressed against a transfer object resin in the form of a plate or a roll, and this imprinting transfer roll 11 is rotated, whereby the recessed-protruded pattern on the surface of the resin mold 22 can be transferred to the transfer object resin.

It is preferable that the resin mold 22 is not arranged astride the j oint edge surface between one divided body 12 and the other divided body 14, as shown in Fig. 5. In other words, it is preferable that the whole of the resin mold 22 is arranged on one divided body 12. If a part of the resin mold 22 is arranged astride the joint edge surface, a difference in level is formed though it is small. Under such circumstance, good transfer cannot be expected.

In order to cope with such a situation, it is preferable in the present invention that when the roll body is divided into one divided body 12 and the other divided body 14, the roll body is not divided in the middle differently from the roll body shown in Fig. 1, and for example, the divided faces are biased so that one divided body 12 may be set to be larger than the other divided body 14, as shown in Fig. 5.

By setting the dividedbodies as above, the length of the circular arc-shaped outer peripheral surface of one divided body 12 can be ensured largely, and therefore, the resin mold 22 can be prevented from straddling the divided faces of the imprinting transfer roll 10, and as a result, occurrence of a difference in level can be prevented.

### Industrial Applicability

The imprinting transfer roll of the present invention can be used in an imprinting device.

### Reference Signs List

10: imprinting transfer roll
10a: roll body
11: imprinting transfer roll having recessed-protruded pattern on surface
12: first divided body
12a: divided face
14: second divided body
16: pin
18: pin hole
20: resin film substrate
22: resin mold
24: mounting hole
26: screw

## Claims

1. An imprinting transfer roll comprising a roll body around a peripheral surface of which a resin film substrate is to be wound, to said resin film substrate a resin mold having a fine recessed-protruded pattern formed on its surface having been affixed, wherein:
the roll body is divided into two and thereby constituted of one divided body and the other divided body, and between divided faces of these first divided body and second divided body to be joined together, one end of the resin film substrate is to be sandwiched to integrate the first divided body and the second divided body, and then the resin film substrate is to be wound around in the circumferential direction of the roll body.

2. The imprinting transfer roll as claimed in claim 1, wherein a pin protrudes from the divided face of the one divided body, a pin hole fitted to the pin is formed on the joint surface of the other divided body, and the one divided body and the other divided body are integrated by pinned connection constituted of the pin and the pin hole.

3. The imprinting transfer roll as claimed in claim 2, wherein in one end part of the resin film substrate, at least one mounting hole is formed, and the one divided body and the other divided body are integrated in a state where the pin is mounted into this mounting hole.

4. The imprinting transfer roll as claimed in claim 2, wherein the angle α between the divided face of the divided body having a pin and a tangent line to the roll body on the outer periphery of the roll body at the divided face is 91° to 170°.

5. An imprinting transfer roll having a recessed-protrudedpattern on its surface, said imprinting transfer roll comprising the imprinting transfer roll as claimed in any one of claims 1 to 4 around which a resin film substrate having a resin mold affixed thereto has been wound.

## Patentansprüche

1. Prägeübertragungsrolle, die einen Rollenkörper umfasst, um eine Randoberfläche dessen ein Harzfilmsubstrat herumzuwickeln ist, wobei auf dem Harzfilmsubstrat eine Harzform aufgebracht worden ist, die auf ihrer Oberfläche ein feines Muster mit Vertiefungen und Vorsprüngen aufweist, wobei:
der Rollenkörper in zwei geteilt ist und dadurch aus einem geteilten Körper und dem anderen geteilten Körper ausgebildet ist und zwischen geteilten Flächen dieses ersten geteilten Körpers und zweiten geteilten Körpers, die miteinander zu verbinden sind, ein Ende des Harzfilmsubstrats sandwichartig einzubringen ist, um den ersten geteilten Körper und den zweiten geteilten Körper zu integrieren, und dann das Harzfilmsubstrat in die Umfangsrichtung des Rollenkörpers herumzuwickeln ist.

2. Prägeübertragungsrolle nach Anspruch 1, wobei ein Zapfen von der geteilten Fläche des einen geteilten Körpers hervorsteht, ein Zapfenloch, das an den Zapfen angepasst ist, auf der Verbindungsoberfläche des anderen geteilten Körpers gebildet ist, und der eine geteilte Körper und der andere geteilte Körper durch die verzapfte Verbindung, die durch den Zapfen und das Zapfenloch ausgebildet ist, integriert sind.

3. Prägeübertragungsrolle nach Anspruch 2, wobei in einem Endstück des Harzfilmsubstrats mindestens ein Montageloch gebildet ist und der eine geteilte Körper und der andere geteilte Körper in einem Zustand integriert sind, in dem der Zapfen in dieses Montageloch montiert ist.

4. Prägeübertragungsrolle nach Anspruch 2, wobei der Winkel α zwischen der geteilten Fläche des geteilten Körpers, die einen Zapfen aufweist, und einer Tangentiallinie zu dem Rollenkörper auf dem äußeren Rand des Rollenkörpers an der geteilten Fläche 91° bis 170° ist.

5. Prägeübertragungsrolle, die auf ihrer Oberfläche ein Muster mit Vertiefungen und Vorsprüngen aufweist, wobei die Prägeübertragungsrolle die Prägeübertragungsrolle nach einem der Ansprüche 1 bis 4 umfasst, um die ein Harzfilmsubstrat herumgewickelt worden ist, auf dem eine Harzform aufgebracht ist.

## Revendications

1. Rouleau de transfert d'estampage comprenant un corps de rouleau autour d'une surface périphérique duquel un substrat de film de résine doit être enroulé, un moule de résine ayant un motif fin en creux-en saillie formé sur sa surface ayant été fixé audit substrat de film de résine, dans lequel :
le corps de rouleau est divisé en deux et ainsi constitué d'un premier corps divisé et de l'autre corps divisé, et entre les faces divisées de ces premier corps divisé et second corps divisé destinées à être réunies, une extrémité du substrat de film de résine doit être enserrée pour intégrer le premier corps divisé et le second corps divisé, puis le substrat de film de résine doit être enroulé dans la direction circonférentielle du corps de rouleau.

2. Rouleau de transfert d'estampage selon la revendication 1, dans lequel une broche fait saillie de la face divisée du premier corps divisé, un trou de broche ajusté à la broche est formé sur la surface de jonction de l'autre corps divisé, et le premier corps divisé et l'autre corps divisé sont intégrés par raccord à broche constitué de la broche et du trou de broche.

3. Rouleau de transfert d'estampage selon la revendication 2, dans lequel dans une partie d'extrémité du substrat de film de résine, au moins un trou de montage est formé, et le premier corps divisé et l'autre corps divisé sont intégrés dans un état dans lequel la broche est montée dans ce trou de montage.

4. Rouleau de transfert d'estampage selon la revendication 2, dans lequel l'angle α entre la face divisée du corps divisé ayant une broche et une ligne tangente au corps de rouleau sur la périphérie extérieure du corps de rouleau au niveau de la face divisée va de 91° à 170°.

5. Rouleau de transfert d'estampage ayant un motif en creux-en saillie sur sa surface, ledit rouleau de transfert d'estampage comprenant le rouleau de transfert d'estampage selon l'une quelconque des revendications 1 à 4 autour duquel un substrat de film de résine ayant un moule de résine fixé à celui-ci a été enroulé.
